# EUROPEAN PATENT APPLICATION

(11) **EP 4 842 156 A1**
(43) Date of publication of application: **18.11.2026**
(21) Application number: 26175141.6
(22) Date of filing: 28.04.2026
(51) Int. Cl.: H10D 1/68, H10D 30/47, H10D 84/80, H10D 62/824

(54) **ELECTRONIC DEVICE WITH SHIELDED COMPONENT**

(30) Priority: 14.05.2025 IT 202500010836
(71) Applicant: STMicroelectronics International N.V., 1228 Plan-les-Ouates, Geneva (CH)
(72) Inventor: GAMBERO, Andrea, 20864 AGRATE BRIANZA (MB) (IT); CORONA, Stefano, 20864 AGRATE BRIANZA (MB) (IT); ROSSI, Sandro, 20864 AGRATE BRIANZA (MB) (IT); MARCHESI, Marco, 20864 AGRATE BRIANZA (MB) (IT); TOIA, Fabrizio Fausto Renzo, 20864 AGRATE BRIANZA (MB) (IT)
(74) Representative: Studio Torta S.p.A.

(57) **Abstract**

An electronic device integrated into a single die (2) includes a shielded capacitor (15) and a heterostructure (20) containing gallium nitride and having a heterojunction (20a) and a 2-dimensional electron gas (21) at the heterojunction (20a). The shielded capacitor (15) includes a shield structure (25) and a MIM capacitive module (30) formed over the shield structure (25). The shield structure (25) includes a shield heterostructure portion (20b), a corresponding shield portion (21a) of the 2-dimensional electron gas (21) and shield electrodes (27) delimiting the shield portion (21a) of the 2-dimensional electron gas (21) at opposite ends. The MIM capacitive module (30) is arranged between the shield electrodes (27) and the shield electrodes (27) are coupled so as to be maintained at a same potential.

## Description

### Technical Field

The present invention relates to an electronic device with shielded component.

### Background

As is known, the growing demand for higher energy density and efficiency in power converters, driven by the expansion of so-called *data farms* and the electric vehicle market, is pushing for the adoption of technologies that are innovative and capable of offering high performance. In the semiconductor field, High Electron Mobility Transistors or HEMTs, for example in Gallium Nitride (GaN), are extremely promising for power applications.

The design of power devices, in particular converters, needs to start from the fact that GaN technology normally allows only one type of transistors (almost always N-channel transistors) to be integrated on the same chip. The monolithic integration of complementary transistors (N-channel and P-channel transistors) is instead currently problematic and is not sufficiently developed for industrial-scale applications.

To compensate for the lack of complementary integrated devices, solutions are adopted that, however, in some cases may lead to limitations and undesirable effects. For example, in power converters, such as Buck converters, it is common to use logic gates provided with so-called "bootstrap" components, that essentially act as charge pumps using a floating bootstrap capacitor. In monolithic power converters, such as monolithic Buck converters, the logic gates of the high-voltage side drivers usually have the bootstrap capacitor coupled to the switching node and are therefore exposed to parasitic capacitances towards the common substrate. When the slew rate of the switching node is high, the parasitic capacitances may inject high parasitic currents on the bootstrap capacitor and cause malfunctions or even irreversible damage.

To overcome this drawback, it has been proposed to use two separate dice, one for the high-voltage side and one for the low-voltage side of the converter. This solution is effective in terms of protection from parasitic currents, but implies higher costs for the more complex packaging structure due to the two dice in lieu of one. Furthermore, the occupied area is larger and parasitic inductances due for example to wire bonds increase, that may limit the maximum switching frequency.

According to another solution, a deep trench isolation structure that extends to the silicon substrate interrupts and separates the gallium nitride and aluminium gallium nitride layers that define the heterostructure of HEMT transistors on the high-voltage side from the low-voltage side. The silicon substrate is also contacted by a metal pad for shielding in separation regions between the high-voltage side and the low-voltage side. Achieving this type of insulation, however, requires dedicated process steps and additional masks, that increase costs and may cause reliability issues.

It has also been proposed to use shielded capacitors of the MOM (Metal-Oxide-Metal) type in lieu of MIM (Metal-Insulator-Metal) capacitors to achieve decoupling from the substrate. However, MOM shielded capacitors have a less favorable capacitance/area ratio (capacitance density) and the use of upper metal layers may reduce the possibilities for interconnection.

US 2022/262789 A1 discloses an electronic device integrated into a single die and comprising a shielded capacitor and a heterostructure containing gallium nitride and having a heterojunction and a 2-dimensional electron gas at the heterojunction. The shielded capacitor comprises a shield structure and a MIM capacitive module formed over the shield structure. The shield structure comprises a shield heterostructure portion and a corresponding shield portion of the 2-dimensional electron gas.

### Summary

It is therefore an aim of the present invention to provide an electronic device that allows the limitations described to be to overcome or at least mitigated.

According to the present invention, an electronic device as defined in claim 1 is provided.

### Brief Description of the Figures

For a better understanding of the present invention, preferred embodiments are presented, by way of non-limiting example, with reference to the attached drawings, wherein:
- Figure 1 is a simplified block diagram of an electronic device in accordance with an embodiment of the present invention;
- Figure 2 is a more detailed block diagram of the electronic device of Figure 1;
- Figure 3 is a cross-section through a semiconductor die including components of the electronic device of Figure 1; and
- Figure 4 is a cross-section through a semiconductor die including components of an electronic device in accordance with a different embodiment of the present invention.

### Description of Embodiments

The following description refers to the arrangement shown in the drawings; accordingly, expressions such as "above", "below", "upper", "lower", "top", "bottom", "right", "left" and the like relate to the accompanying Figures and are not to be construed as limiting.

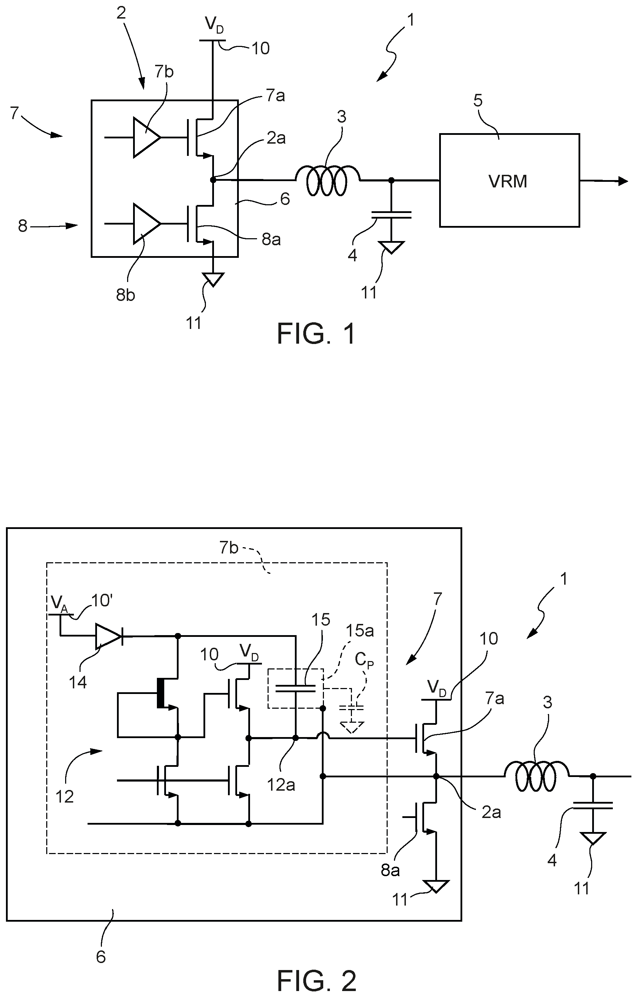

With reference to Figure 1, a power converter in accordance with an embodiment of the present invention, herein not limited to a Buck converter, is indicated by the numeral 1 and comprises a control device 2, a converter inductor 3, an output capacitor 4 and a voltage regulator module 5.

The control device 2 is made by using monolithic GaN (gallium nitride) technology and is integrated into a single die 6. The control device 2 has a switching node 2a, to which a terminal of the converter inductor 3 is coupled, and comprises a high-voltage side 7 and a low-voltage side 8. In this case, the terms "high voltage" and "low voltage" refer to the supply voltage, as is customary in the industry. In particular, the high-voltage side 7 is coupled to a power source having higher voltage, for example a supply line 10 providing a DC supply voltage V_{D}, and the low-voltage side 8 is coupled to a reference line having lower voltage than the DC supply voltage V_{D}, for example a ground line 11.

The high-voltage side 7 of the control device 2 comprises a high-voltage switching transistor 7a and a high-voltage driver 7b. The high-voltage switching transistor 7a is a HEMT (High Electron Mobility Transistor) having conduction terminals (drain and source) coupled respectively to the supply line 10 and to the switching node 2a, and a control terminal (gate) coupled to an output of the driver 7b.

The low-voltage side 8 of the control device 2 comprises a low-voltage switching transistor 8a and a driver 8b. The low-voltage switching transistor 8a is a HEMT (High Electron Mobility Transistor) having conduction terminals coupled to the switching node 2a, and to the ground line 11, respectively, and control terminal coupled to an output of the driver 8b.

The high-voltage switching transistor 7a and the low-voltage switching transistor 8a are both of the N-channel type.

In Figure 2, the high-voltage side 7 is represented in more detail, while for the low-voltage side 8 only the low-voltage switching transistor 8a is shown for simplicity.

The driver 7b comprises a bootstrap logic gate 12, a diode 14 and a bootstrap capacitor 15.

The bootstrap logic gate 12 has first supply terminals connected to the supply line 10 and second supply terminals connected to a local reference, that is defined by the switching node 2a. Furthermore, an output 12a of the bootstrap logic gate 12 is coupled to the gate terminal of the high-voltage switching transistor 7a.

The diode 14 has an anode terminal connected to a supply line 10' providing a DC supply voltage V_{A} and a cathode terminal connected to a first terminal of the bootstrap capacitor 15. The DC supply voltage V_{A} may be obtained for example by connecting the anode terminal of the diode 14 to the switching node 2a by an external capacitor, not illustrated here. A second terminal of the bootstrap capacitor 15 is connected to the output 12a of the bootstrap logic gate 12.

The bootstrap capacitor 15 is provided with a shield 15a for decoupling from the substrate (not shown in detail here) of the die 6 in which the control device 2 is monolithically integrated. As shown in Figure 2, the shield 15a of the bootstrap capacitor 15 is connected to the local reference defined by the switching node 2a and is therefore maintained at the same potential.

As shown in more detail below, the shield 15a decouples the bootstrap capacitor 15 from the substrate, so that the bootstrap capacitor 15 is not affected by the parasitic capacitances, here indicated by C_{P}, that are charged and discharged directly by the switching node 2a.

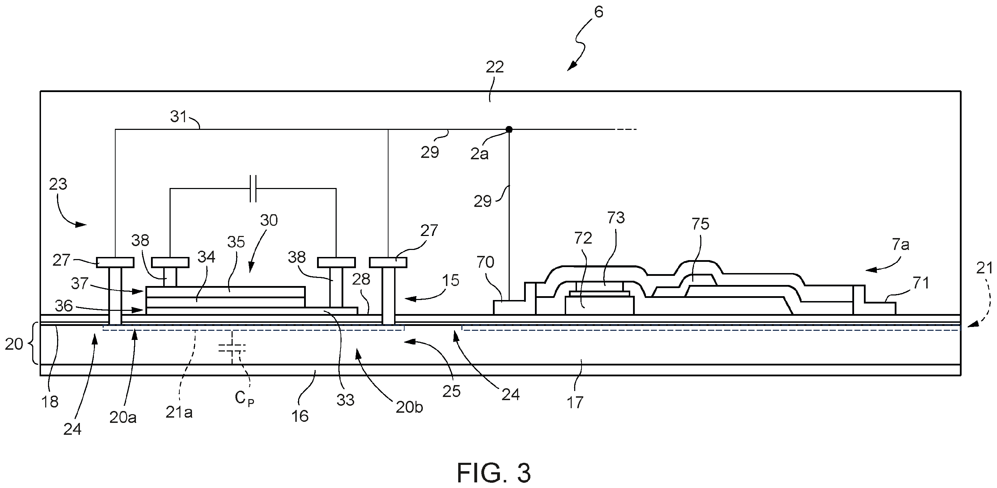

Figure 3 illustrates portions of the die 6 where the bootstrap capacitor 15 according to the invention and, schematically and by way of example, the high-voltage switching transistor 7a are integrated. In particular, the high-voltage switching transistor 7a illustrated in Figure 3 comprises a source electrode 70, a drain electrode 71, a gate semiconductor region 72, a gate electrode 73 and a field plate structure 75. Furthermore, the high-voltage switching transistor 7a comprises respective portions of the heterostructure 20 and the 2-dimensional electron gas 21.

The die 6 comprises a substrate 16 having the function of mechanical support and/or electrical functions, for example of silicon or silicon carbide, a channel layer 17 and a barrier layer 18. The channel layer 17 and the barrier layer 18 are of respective semiconductor materials with different band gaps and form a heterostructure 20, with a heterojunction 20a at a common interface. For example, the channel layer 17 is of intrinsic gallium nitride, while the barrier layer 18 is of aluminium gallium nitride (AlGaN) and has N-type conductivity. A 2-Dimensional Electron Gas (2DEG) 21 is formed in a channel region of the channel layer 17 at the heterojunction 20a.

In addition to the channel layer 17 and the barrier layer 18, the die 6 may comprise other layers belonging to or connected to the heterostructure 20, including, not necessarily and not limited to: a buffer layer between the substrate and the channel layer 17; a spacer layer, for example of aluminium nitride (AlN), between the channel layer 17 and the barrier layer 18; a cap layer, for example of GaN, over the channel layer 17.

The die 6 also comprises a dielectric body 22, for example of silicon oxide, that covers the entire heterostructure 20, and a plurality of upper metallization levels 23 embedded into the dielectric body 22. The upper metallization levels 23, only one of which for simplicity is represented in Figure 3, are normally used for conductive structures that connect the devices of the die 6 to each other and to the outside, in accordance with the design preferences.

The die 6 may further comprise a separation region 24 of dielectric material that interrupts the 2-dimensional electron gas 21 and delimits an island where the bootstrap capacitor 15 is housed. The separation region 24 may be obtained for example by an argon implant, that suppresses the 2-dimensional electron gas 21 selectively where appropriate. In particular, the 2-dimensional electron gas 21 is preserved in the island where the bootstrap capacitor 15 is located and is suppressed therearound.

The bootstrap capacitor 15 is embedded into the dielectric body 22 and comprises a shield structure 25, and a MIM (Metal-Insulator-Metal) capacitive module 30 formed over the shield structure 25.

The shield structure 25 comprises a shield heterostructure portion 20b with a corresponding shield portion 21a of the 2-dimensional electron gas 21, in particular in the island delimited by the separation region 24 if present, and shield electrodes 27. The MIM capacitive module 30, that is formed over the shield structure 25 between the shield electrodes 27, is separated from the heterostructure 21 by an insulating layer 28, for example of silicon nitride. It is understood that the insulating layer 28 may also be defined by a plurality of layers of the same dielectric material or even of different dielectric materials.

In more detail, the shield portion 21a of the 2-dimensional electron gas 21 is delimited at opposite ends by the shield electrodes 27, for example one per side. The shield electrodes 27 extend from the upper metallization levels 23 to the shield heterostructure portion 20b (in particular to the barrier layer 18) through the insulating layer 28 and are equipotential. For example, the shield electrodes 27 may be directly connected to each other through connection structures 31 formed in one or more of the upper metallization levels 23. Alternatively, the shield electrodes 27 may be connected to respective pads of the die 6 biased to a same voltage.

The shield electrodes 27 are further connected to a local reference node, for example the switching node 2a, by connection lines 29 formed in the upper metallization levels 23 and illustrated only schematically in Figure 3.

The MIM capacitive module 30 comprises a first metal plate 33, an insulating structure 34 and a second metal plate 35. The first metal plate 33 and the second metal plate 35 may be formed from lower metallization levels that are between the heterostructure 20 and the upper metallization levels 23. The lower metallization levels are also used to form structures of the switching transistors 7a, 8a and the transistors of the drivers 7b, 8b (in particular for the bootstrap logic gate 12 of the high-voltage driver 7b). In a non-limiting embodiment, in particular, the lower metallization levels include a field plate metallization level 36 and a gate metallization level 37 from which the field plate structure 75 and the gate electrode 73 of the high-voltage switching transistor 7a are also formed, respectively.

In detail, the first metal plate 33 is formed, for example from the field plate metallization level, in contact with the insulating layer 28 and is arranged between the shield electrodes 27. The insulating layer 28 is therefore in contact on one side with the shield heterostructure portion 20b (in particular with the barrier layer 18) and on the other with the first metal plate 33. More precisely, a lower face of the first metal plate 33 is entirely in contact with the insulating layer 28, and between the first metal plate 33 and the shield heterostructure portion 20b no semiconductor materials are interposed.

The insulating structure 34, in a non-limiting embodiment silicon oxide, separates the first metal plate 33 from the second metal plate 35 and has a thickness lower than 120 nm, for example 100 nm, so as to obtain a high capacitance value.

The second metal plate 35 extends on the insulating structure 34 in contact therewith and in plan occupies a portion of the area occupied by the first metal plate 33. More precisely, the first metal plate 33 is larger than the second metal plate 35 and, for example, of the insulating structure 34 and protrudes laterally. Capacitor electrodes 38 extend from the upper metallization levels 23 to the bootstrap capacitor 15, in particular one to the first metal plate, in the part protruding with respect to the insulating structure 34, and one to the second metal plate 35. Connection lines not shown and formed in the upper metallization levels 23 connect the capacitor electrodes 38, that define the terminals of the bootstrap capacitor 15, to the cathode terminal of the diode 14 and to the output 12a of the bootstrap logic gate 12 (Figure 2).

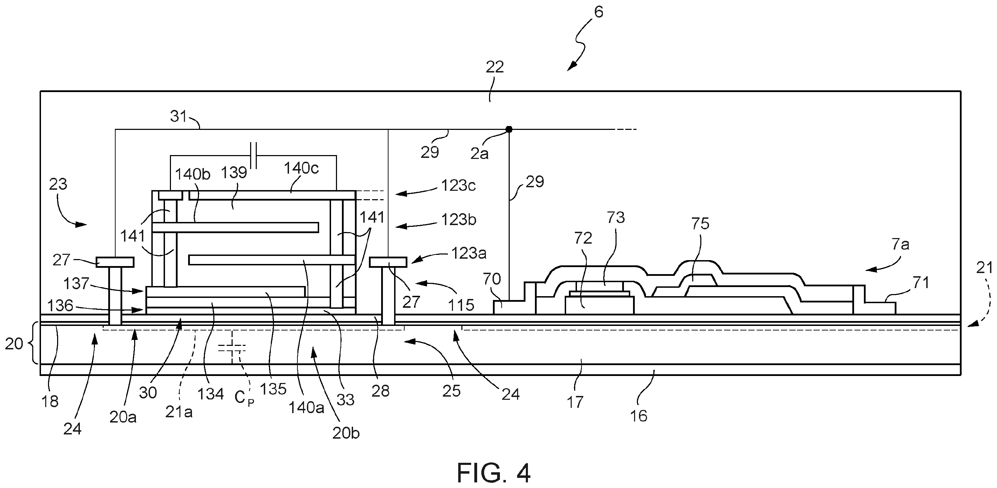

According to a different embodiment illustrated in Figure 4, where parts equal to those already described are indicated with the same reference numerals, a power converter has substantially the same circuit structure as the power converter 1 of Figures 2 and 3 and is distinguished by the structure of the bootstrap capacitor here indicated by 115, that comprises a MIM capacitive module 130, an upper insulating structure 139 and upper metal plates formed from the upper metallization levels. In particular, the upper metallization levels here include a first upper metallization level 123a, from which a first upper metal plate 140a is formed, a second upper metallization level 123b, from which a second upper metal plate 140b is formed, and a third upper metallization level 123c, from which a third upper metal plate 140c is formed. The first upper metallization level 123a and the third upper metallization level 123c are the closest to and the furthest from the heterostructure 20, respectively.

The MIM capacitive module 130 comprises a first lower metal plate 133, a lower insulating structure 134 and a second lower metal plate 135. The first lower metal plate 133 and the second lower metal plate 135 may be formed from lower metallization levels that are between the heterostructure 20 and the upper metallization levels 123a-c, in particular respectively from a field plate metallization level 136 and a gate metallization level 137 used to form respectively field plate structures and gate electrodes (not shown here) for the switching transistors 7a, 8a (in particular the field plate structure 75 and the gate electrode 73 of the high-voltage switching transistor 7a) and the transistors of the drivers 7b, 8b (in particular for the bootstrap logic gate 12 of the high-voltage drivers 7b) .

In detail, the first lower metal plate 133 is formed in contact with the insulating layer 28 and is arranged between the shield electrodes 27. As already described, the insulating layer 28 is therefore in contact on one side with a shield heterostructure portion 20b and on the other with the first lower metal plate 133. The lower insulating structure 134 is a thin silicon oxide layer that separates the first lower metal plate 133 from the second lower metal plate 135 and has a thickness lower than 120 nm, for example 100 nm.

The second lower metal plate 135 extends on the lower insulating structure 134 in contact therewith and in plan occupies a portion of the area occupied by the first lower metal plate 133, that is larger.

The upper insulating structure 139 separates the upper metal plates 140a-c from each other and from the second lower metal plate 135.

Interconnection vias 141 connect alternate levels of the bootstrap capacitor 115. More precisely, the first lower metal plate 133 is connected to the first upper metal plate 140a, that is in turn connected to the third upper metal plate 140c.

To facilitate connections, the second lower metal plate 135 and the upper metal plates 140a-c are offset, so as to define a serpentine path therebetween that is occupied by the upper insulating structure 139, that is defined by portions of intermetallic insulating layers that form the dielectric body 22. Although the intermetallic insulating layers have a greater thickness than the lower insulating structure 134 and therefore allow a lower capacitance density, the upper metal plates 140a-c form, with the lower metal plates 133, 135, parallel-connected capacitors. The overall result is therefore an increase in capacitance per area unit of the die 6.

The electronic device according to the invention exploits the presence of the 2-dimensional electron gas to shield and decouple the bootstrap capacitor from parasitic capacitances with respect to the substrate where the same bootstrap capacitor is integrated. The shield electrodes, between which the bootstrap capacitor is located, are maintained at the same potential and consequently create an equipotential conductive region in the 2-dimensional electron gas. Since the equipotential conductive region is interposed between the bootstrap capacitor and the die substrate, the bootstrap capacitor is not affected by the effects of the parasitic capacitances. Furthermore, the connection to a local reference node, such as the communication node, allows the parasitic capacitances to be charged and discharged through the switching transistors instead of through the bootstrap capacitor. A double advantage is thus obtained. On the one hand, in fact, the switching of the logic gates may be made faster or, alternatively, the fan-out may be increased without sacrificing the switching speed. On the other hand, the injection of parasitic currents and overvoltage that might cause malfunctions or damage the electronic device even permanently may be avoided.

Furthermore, the shield structure allows the use of MIM capacitive modules provided in the lower metallization levels, from which the metal structures of the HEMT transistors (field plates and gate metallizations) are also formed. Furthermore, thin dielectric layers may be exploited to form the insulating structure between the metal plates of the MIM capacitive modules, obtaining high capacitance densities to the advantage of the occupied area.

## Claims

1. An electronic device integrated into a single die (2) and comprising a shielded capacitor (15; 115) and a heterostructure (20) containing gallium nitride and having a heterojunction (20a) and a 2-dimensional electron gas (21) at the heterojunction (20a);
wherein the shielded capacitor (15; 115) comprises a shield structure (25) and a MIM capacitive module (30; 130) formed over the shield structure (25);
wherein the shield structure (25) comprises a shield heterostructure portion (20b), a corresponding shield portion (21a) of the 2-dimensional electron gas (21) and shield electrodes (27) delimiting the shield portion (21a) of the 2-dimensional electron gas (21) at opposite ends;
wherein the MIM capacitive module (30; 130) is arranged between the shield electrodes (27);
and wherein the shield electrodes (27) are coupled so as to be maintained at a same potential.

2. The device according to claim 1, wherein the shield electrodes (27) are connected to a reference node (2a).

3. The device according to claim 1 or 2, wherein the shield electrodes (27) are directly connected to each other.

4. The device according to any of the preceding claims, wherein the MIM capacitive module (30; 130) is separated from the shield heterostructure portion (20b) by an insulating layer (28).

5. The device according to claim 4, wherein the MIM capacitive module (30; 130) comprises a first metal plate (33; 133) and a second metal plate (35; 135), separated from each other by an insulating structure (34; 134) and wherein the first metal plate (33; 133) is in contact with the insulating layer (28).

6. The device according to claim 5, wherein the second metal plate (35; 135) extends on the insulating structure (34; 134) in contact therewith and in plan occupies a portion of the area occupied by the first metal plate (33; 133), the first metal plate (33; 133) being larger than the second metal plate (35; 135).

7. The device according to claim 5 or 6, wherein the insulating layer (28) is in contact on one side with the shield heterostructure portion (20b) and on the other with the first metal plate (33; 133) and wherein a lower face of the first metal plate (33; 133) is entirely in contact with the insulating layer (28).

8. The device according to any of claims 5 to 7, comprising upper metallization levels (123a-c) arranged over the second metal plate (35; 135);
wherein the capacitor (115) comprises upper metal plates (140a-c) formed from the upper metallization levels (123a-c), an upper insulating structure (139) separating the upper metal plates (140a-c) from each other and from the MIM capacitive module (130), and interconnection vias (141) that connect upper metal plates (140a-c) of alternate upper metallization levels (123a-c).

9. The device according to any of the preceding claims, comprising a separation region (24) of dielectric material that interrupts the heterostructure (20) and delimits the shield heterostructure portion (20b).

10. A converter comprising a control device (2) comprising a first and a second HEMT switching transistor (7a, 8a) and a first and a second driver (7b, 8b) configured to drive the first and second HEMT switching transistors (7a, 8a), respectively;
wherein the first HEMT switching transistor (7a) is connected, on one side, to a first supply line (10) and, on the other side, to a switching node (2a);
wherein the second HEMT switching transistor (8a) is connected, on one side, to a second supply line (11) and, on the other side, to the switching node (2a);
and wherein at least one of said first and second drivers (7b; 8b) comprises the electronic device according to any of the preceding claims.
